# EUROPEAN PATENT APPLICATION

(11) **EP 4 723 474 A1**
(43) Date of publication of application: **08.04.2026**
(21) Application number: 24818656.1
(22) Date of filing: 04.06.2024
(51) Int. Cl.: H03D 1/18, H04L 27/06

(54) **ENVELOPE DETECTOR, AMPLITUDE DEMODULATOR, AND ELECTRONIC DEVICE**

(30) Priority: 09.06.2023 CN 202310685499
(71) Applicant: Huawei Technologies Co., Ltd., Shenzhen, Guangdong 518129 (CN)
(72) Inventor: YANG, Tiandong, Shenzhen, Guangdong 518129 (CN); XU, Liang, Shenzhen, Guangdong 518129 (CN); GUO, Chunlong, Shenzhen, Guangdong 518129 (CN); WANG, Kailin, Shenzhen, Guangdong 518129 (CN)
(74) Representative: Gill Jennings & Every LLP
(86) International application number: PCT/CN2024/097365
(87) International publication number: WO 2024/251124

(57) **Abstract**

Embodiments of this application provide an envelope detector, an amplitude demodulator, and an electronic device, and are applied to the field of electronic component signal processing technologies. The envelope detector includes a comparator circuit and a first filter circuit. An output end of the comparator circuit is coupled to an input end of the first filter circuit. A first input end of the comparator circuit is configured to be input with a first analog signal. A second input end of the comparator circuit is configured to be input with a first reference signal. The comparator circuit is configured to output a first direct-current signal based on the first analog signal and the first reference signal. A level of the first direct-current signal indicates a value relationship between the first analog signal and the first reference signal. The first filter circuit is configured to output a first envelope signal based on the first direct-current signal. A signal amplitude of the first envelope signal indicates a signal peak of the first direct-current signal. In embodiments of this application, envelope detection with low costs, high processing precision, and a high processing rate on the first analog signal is implemented.

## Description

This application claims priority to Chinese Patent Application No. 202310685499.3, filed with the China National Intellectual Property Administration on June 9, 2023 and entitled "ENVELOPE DETECTOR, AMPLITUDE DEMODULATOR, AND ELECTRONIC DEVICE", which is incorporated herein by reference in its entirety.

### TECHNICAL FIELD

This application relates to the field of electronic component signal processing technologies, and in particular, to an envelope detector, an amplitude demodulator, and an electronic device.

### BACKGROUND

An envelope detector is disposed in each of many electronic devices (for example, a transmitting device and a receiving device). The envelope detector processes an input analog signal, to obtain a corresponding envelope signal. The electronic device performs subsequent signal processing based on the generated envelope signal, to implement various functions. The envelope detector may be implemented in a plurality of manners. However, a low-cost envelope detector usually has low processing precision and a low processing rate, while an envelope detector with high processing precision and a high processing rate has a very complex structure and very high component costs.

### SUMMARY

Embodiments of this application provide an envelope detector, an amplitude demodulator, and an electronic device, to obtain an envelope detector with low costs, a high processing rate, and high processing precision.

To achieve the foregoing objectives, the following technical solutions are used in embodiments of this application.

According to a first aspect, an envelope detector is provided. The envelope detector includes a comparator circuit and a first filter circuit. An output end of the comparator circuit is coupled to an input end of the first filter circuit. A first input end of the comparator circuit is configured to be input with a first analog signal. A second input end of the comparator circuit is configured to be input with a first reference signal. The comparator circuit is configured to output a first direct-current signal based on the first analog signal and the first reference signal. The first analog signal carries a first data signal, and a signal amplitude of the first analog signal indicates values of a plurality of bits of the first data signal. A level of the first direct-current signal indicates a value relationship between the first analog signal and the first reference signal. The first filter circuit is configured to output a first envelope signal based on the first direct-current signal, where a signal amplitude of the first envelope signal indicates values of a plurality of bits of the first data signal.

In this embodiment of this application, a voltage value of the first reference signal is determined based on an ASK modulation parameter and the like of the first analog signal received in an actual application scenario. The first reference signal and the first analog signal are input via the comparator circuit, and a value of the first reference signal and a value of the first analog signal are compared to obtain the first direct-current signal. The level of the first direct-current signal may indicate the value relationship between the first analog signal and the first reference signal, that is, indicate a signal peak of the first analog signal and a signal amplitude of the first reference signal. Then, the first envelope signal is obtained through filtering on the first direct-current signal, and the first envelope signal may indicate values of a plurality of bits of the first data information carried in the first analog signal. In this embodiment of this application, the comparator circuit is combined with the first filter circuit, so that envelope detection with low costs, high processing precision, and a high processing rate on the first analog signal is implemented.

In a possible implementation, the first analog signal carries a common-mode interference signal. The envelope detector further includes an anti-common-mode interference circuit. The anti-common-mode interference circuit is coupled to the first input end of the comparator circuit. In this embodiment of this application, when the common-mode interference signal exists, impact of the common-mode interference signal on the comparator circuit can be eliminated via the anti-common-mode interference circuit.

In some examples, the anti-common-mode interference circuit may be a common-mode interference filter circuit. In this case, the anti-common-mode interference circuit is configured to: be input with the first analog signal carrying the common-mode interference signal, and output, to the comparator circuit, the first analog signal from which the common-mode interference signal is filtered out. For example, the common-mode interference filter circuit may be an anti-common-mode coupled inductor or the like. In this embodiment of this application, the common-mode interference signal may be directly filtered out to eliminate interference.

In some examples, the anti-common-mode interference circuit is a second filter circuit. A first end of the second filter circuit is coupled to the first input end of the comparator circuit. A second end of the second filter circuit is coupled to the second input end of the comparator circuit. The second filter circuit is configured to: be input with the first analog signal through the first end of the second filter circuit, and output the common-mode interference signal to the second input end of the comparator circuit through the second end of the second filter circuit. In this embodiment of this application, the common-mode interference signal may be separately transmitted to the first input end and the second input end of the comparator circuit. When the comparator circuit performs comparison, the common-mode interference signals at the two input ends may compensate for a comparison voltage difference during comparison of voltage values, to eliminate interference.

In a possible implementation, the second filter circuit includes a first equivalent resistor. A first end of the first equivalent resistor is coupled to the first input end of the comparator circuit. A second end of the first equivalent resistor is coupled to the second input end of the comparator circuit. The first equivalent resistor is configured to: be input with the first analog signal through the first end of the first equivalent resistor, and output the common-mode interference signal to the second input end of the comparator circuit through the second end of the first equivalent resistor.

In a possible implementation, the first equivalent resistor is further configured to: output the first reference signal to the second input end of the comparator circuit through the second end of the first equivalent resistor. In this embodiment of this application, a frequency response for the common-mode interference signal may be implemented via an equivalent resistor, to filter and transmit the common-mode interference signal from the first input end of the comparator circuit to the second input end.

In a possible implementation, the second filter circuit includes a first equivalent capacitor. A first end of the first equivalent capacitor is coupled to the first input end of the comparator circuit. A second end of the first equivalent capacitor is coupled to the second input end of the comparator circuit. The first equivalent capacitor is configured to: be input with the first analog signal through the first end of the first equivalent capacitor, and output the common-mode interference signal to the second input end of the comparator circuit through the second end of the first equivalent capacitor. In this embodiment of this application, a frequency response for the common-mode interference signal may be implemented via an equivalent capacitor, to filter and transmit the common-mode interference signal from the first input end of the comparator circuit to the second input end.

In a possible implementation, the envelope detector further includes a first equivalent resistor. A first end of the first equivalent resistor and the first end of the first equivalent capacitor are connected in parallel and then coupled to the first input end of the comparator circuit. A second end of the first equivalent resistor and the second end of the first equivalent capacitor are connected in parallel and then coupled to the second input end of the comparator circuit. The first equivalent resistor is configured to: be input with the first analog signal through the first end of the first equivalent resistor, and output the first reference signal to the second input end of the comparator circuit through the second end of the first equivalent resistor. In this embodiment of this application, in some examples, voltage division may be implemented via the first equivalent resistor, to generate the first reference signal. The common-mode interference signal is filtered and transmitted via the first equivalent capacitor. In some examples, voltage division may be implemented via the first equivalent resistor, to generate the first reference signal. The common-mode interference signal is filtered and transmitted via the first equivalent resistor and the first equivalent capacitor.

In a possible implementation, the envelope detector further includes a second equivalent resistor. A first end of the second equivalent resistor is coupled to the first input end of the comparator circuit, and a second end of the second equivalent resistor is grounded. In this embodiment of this application, a comparison voltage difference between the first input end and the second input end of the comparator circuit may be adjusted via the second equivalent resistor, to match different comparison voltage differences in different scenario requirements, so as to improve processing precision of the envelope detector.

In a possible implementation, the envelope detector further includes a reference signal circuit. The second filter circuit includes the first equivalent capacitor. An output end of the reference signal circuit is coupled to the second input end of the comparator circuit. The first end of the first equivalent capacitor is coupled to the first input end of the comparator circuit. The second end of the first equivalent capacitor is coupled to the second input end of the comparator circuit. The reference signal circuit is configured to: output the first reference signal to the first input end of the comparator circuit. In this embodiment of this application, the first reference signal may be generated via the reference signal circuit. Alternatively, the first reference signal is generated by combining the reference signal circuit and the first equivalent resistor.

In a possible implementation, the envelope detector further includes a first bias circuit. An output end of the first bias circuit is coupled to the first input end of the comparator circuit. The first bias circuit is configured to: output a first bias voltage to the first input end of the comparator circuit. In this embodiment of this application, a voltage at the first input end of the comparator circuit is adjusted via the first bias circuit, to adjust the comparison voltage difference between the first input end and the second input end of the comparator circuit, to match different comparison voltage differences in different scenario requirements, so as to improve processing precision of the envelope detector.

In a possible implementation, the envelope detector further includes a second bias circuit. An output end of the second bias circuit is coupled to the second input end of the comparator circuit. The second bias circuit is configured to: output a second bias voltage to the second input end of the comparator circuit. In this embodiment of this application, a voltage at the second input end of the comparator circuit is adjusted via the second bias circuit, to adjust the comparison voltage difference between the first input end and the second input end of the comparator circuit, to match different comparison voltage differences in different scenario requirements, so as to improve processing precision of the envelope detector.

In a possible implementation, the envelope detector further includes an amplitude limiting circuit. The amplitude limiting circuit is coupled to the first input end of the comparator circuit. In this embodiment of this application, the amplitude limiting circuit performs signal amplitude limiting on the first analog signal input to the envelope detector, to avoid problems such as a loss and interference to a downstream component.

According to a second aspect, an embodiment of this application further provides an amplitude demodulator. The amplitude demodulator includes a shaping circuit and the envelope detector described in the first aspect. An output end of the envelope detector is coupled to an input end of the shaping circuit. The envelope detector is configured to: be input with a first analog signal, and output an envelope signal to the shaping circuit, where the first analog signal carries a first data signal, and a signal amplitude of the first analog signal indicates values of a plurality of bits of the first data signal. The shaping circuit is configured to obtain a first level signal based on the envelope signal, where a level of the first level signal indicates values of a plurality of bits of the first data signal.

According to a third aspect, an embodiment of this application further provides an electronic device. The electronic device includes a circuit board and the envelope detector described in the first aspect, where the envelope detector is disposed on the circuit board.

According to a fourth aspect, an embodiment of this application further provides a chip system. The chip system includes at least one controller and at least one interface circuit. The at least one controller and the at least one interface circuit may be interconnected through a line. The controller is configured to support the chip system in implementing functions or steps in the foregoing method embodiments. The at least one interface circuit may be configured to receive a signal from another apparatus (for example, a communication interface, a data processing circuit, a baseband signal generation circuit, a power amplification system, an antenna, a processor, or a memory), or send a signal to another apparatus (for example, a communication interface, a data processing circuit, a baseband signal generation circuit, a power amplification system, an antenna, a processor, or a memory). The chip system may include a chip, and may further include another discrete component.

For technical principles and beneficial effects of the second aspect, the third aspect, and the fourth aspect, refer to related descriptions of the first aspect. Details are not described herein again.

### BRIEF DESCRIPTION OF DRAWINGS

FIG. 1 is a diagram of a switch modulation of a signal according to an embodiment of this application;
FIG. 2 is a diagram of a structure of a receiving device according to an embodiment of this application;
FIG. 3 is a diagram of a structure of a first amplitude demodulator according to an embodiment of this application;
FIG. 4 is a diagram of a structure of a second amplitude demodulator according to an embodiment of this application;
FIG. 5 is a diagram of signal demodulation of the second amplitude demodulator shown in FIG. 4 according to an embodiment of this application;
FIG. 6 is a diagram 1 of a structure of an envelope detector according to an embodiment of this application;
FIG. 7 is a diagram of signal demodulation of the envelope detector shown in FIG. 6 according to an embodiment of this application;
FIG. 8 is a diagram 2 of another structure of an envelope detector according to an embodiment of this application;
FIG. 9 is a diagram of signal demodulation of the envelope detector shown in FIG. 8 according to an embodiment of this application;
FIG. 10 is a diagram 3 of a structure of another envelope detector according to an embodiment of this application;
FIG. 11 is a diagram 4 of still another structure of an envelope detector according to an embodiment of this application;
FIG. 12 is a diagram 5 of still another structure of still another envelope detector according to an embodiment of this application;
FIG. 13 is a diagram 6 of still another structure of an envelope detector according to an embodiment of this application;
FIG. 14 is a diagram 7 of still another structure of an envelope detector according to an embodiment of this application;
FIG. 15 is a diagram 8 of still another structure of an envelope detector according to an embodiment of this application;
FIG. 16 is a diagram 9 of still another structure of an envelope detector according to an embodiment of this application;
FIG. 17 is a diagram 10 of still another structure of an envelope detector according to an embodiment of this application; and
FIG. 18 is a diagram of a structure of a chip system according to an embodiment of this application.

### DESCRIPTION OF EMBODIMENTS

It should be noted that the terms such as "first" and "second" in embodiments of this application are merely used to distinguish between features of a same type, and cannot be understood as an indication of relative importance, a quantity, a sequence, or the like.

The term "example", "for example", or the like in embodiments of this application is used to represent giving an example, an illustration, or a description. Any embodiment or design scheme described as an "example" or "for example" in this application should not be explained as being more preferred or having more advantages than another embodiment or design scheme. Exactly, use of the term "example", "for example", or the like is intended to present a relative concept in a specific manner.

The terms "coupling" and "connection" in embodiments of this application should be understood in a broad sense. For example, the terms may be a physical direct connection, or may be an indirect connection implemented through an electronic component, for example, a connection implemented through a resistor, an inductor, a capacitor, or another electronic component.

First, some basic concepts in embodiments of this application are described.

Detector: The detector is a component configured to detect useful information in a fluctuating analog signal, and may be configured to identify existence or change of a wave, an oscillation, or a signal. The detector is usually configured to extract information carried in an analog signal. The detector may be generally classified into a synchronous detector, an envelope detector, and the like. An envelope signal output by the envelope detector is in a correspondence with an envelope of an input analog signal. The output envelope signal may be used by a transmitting device for detection and feedback on a to-be-transmitted modulation signal, or may be used by a receiving device for demodulation on a received modulation signal.

Modulation and demodulation: Modulation and demodulation are important means of modern communication. Modulation is to control, by using a data signal, some parameters (for example, a phase and an amplitude) of a waveform of a carrier signal that is an analog signal, to obtain a modulation signal. The modulation signal is an analog signal, and a parameter of a waveform of the modulation signal varies with a parameter of the data signal (that is, the data signal is carried in the carrier signal). Demodulation is an inverse process of modulation, and is a process of restoring the data signal from the modulation signal. Based on whether the data signal carried in the carrier signal is an analog signal or a digital signal, modulation technologies may be classified into analog modulation and digital modulation. Digital modulation may be further classified into amplitude shift keying (amplitude shift keying, ASK), frequency shift keying (frequency shift keying, FSK), phase shift keying (phase shift keying, PSK), and the like.

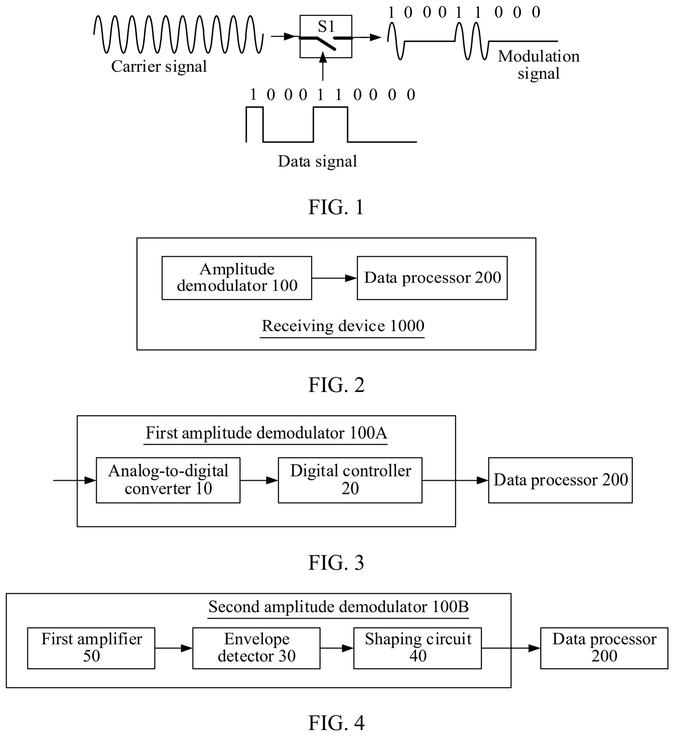

ASK modulation is a modulation mode in which an amplitude change of the carrier signal is controlled based on a data value of the data signal in a digital signal form. The amplitude of the carrier signal is adjusted based on the data value of the data signal, to obtain a modulation signal obtained through ASK modulation. For example, a simple ASK modulation mode is switch (On-Off Keying, OOK) modulation. As shown in FIG. 1, OOK modulation is performed based on a modulation switch S1. The modulation switch S1 is configured to receive a carrier signal and a data signal, where the data signal is in a digital signal form. The data signal is used to control on and off of the modulation switch S1. To be specific, the data signal has a plurality of bits, and the plurality of bits are combined to obtain a string of data values. Each bit has a different level, and different levels correspond to different data values of each bit. Each bit of the data signal is sequentially sent to the modulation switch S1. When the data signal is at a first level (for example, a high level representing data 1), the modulation switch S1 is controlled to be turned on, so that the carrier signal is output. When the data signal is at a second level (for example, a low level representing data 0), the modulation switch S1 is controlled to be turned off, so that the carrier signal is not output. A modulation signal is obtained based on a waveform of a signal that is output by the modulation switch S1 in a period of time. A signal amplitude corresponding to a waveform of the modulation signal corresponds to the data value of the data signal. A transmitting device transmits the modulation signal. After receiving the modulation signal, a receiving device detects the amplitude of the modulation signal to obtain the corresponding data value of the data signal. In this way, demodulation of the modulation signal is completed. Therefore, in ASK modulation, a signal peak of the modulation signal varies with the data value of the data signal. Signal peak points of the modulation signal are connected to obtain an envelope, and a change of the envelope corresponds to a change of the data value of the data signal.

An embodiment of this application provides an electronic device. The electronic device includes a circuit board and an envelope detector. The envelope detector is disposed on the circuit board. For example, the electronic device may be a receiving device, a transmitting device, a signal processing device, or the like.

For example, the electronic device is a receiving device. As shown in FIG. 2, a receiving device 1000 includes an amplitude demodulator 100 and a data processor 200. The amplitude demodulator 100 is configured to output a first level signal based on a first analog signal. The first analog signal carries a first data signal, and a signal amplitude of the first analog signal indicates values of a plurality of bits of the first data signal. A level of the first level signal indicates values of a plurality of bits of the first data signal. In this embodiment of this application, the first analog signal is a modulation signal that carries the first data signal after ASK modulation. The amplitude demodulator 100 obtains the first level signal based on the first analog signal. The level of the first level signal corresponds to the values of the plurality of bits of the first data signal.

In some possible implementations, the amplitude demodulator 100 shown in FIG. 2 may be a first amplitude demodulator that performs digital detection based on an analog-to-digital converter. As shown in FIG. 3, a first amplitude demodulator 100A includes an analog-to-digital converter 10 and a digital controller 20. The analog-to-digital converter 10 is configured to: be input with a first analog signal, and convert the first analog signal into a first digital signal through analog-to-digital conversion. A value of the first digital signal indicates a signal amplitude of the first analog signal. The digital controller 20 is configured to output a first level signal based on the first digital signal. In this embodiment of this application, the first analog signal is converted into the first digital signal through analog-to-digital conversion, and the value of the first digital signal indicates an amplitude of a waveform of the first analog signal. In this way, digital detection is completed. Then, the digital controller 20 outputs the first level signal based on the value of the first digital signal. In this embodiment of this application, when the analog-to-digital converter 10 is used, an additional controller needs to be disposed to manage and control an analog-to-digital conversion process. Consequently, hardware complexity of the amplitude demodulator 100 is greatly increased. In addition, a processing rate and processing precision of digital detection depend on a processing rate and processing precision of the analog-to-digital converter 10. The processing rate and processing precision of the analog-to-digital converter 10 are positively correlated with the hardware complexity of the analog-to-digital converter 10. When digital detection with a high processing rate and high processing precision is required, hardware complexity and hardware costs in the embodiment shown in FIG. 3 are usually extremely high.

In some possible implementations, the amplitude demodulator 100 shown in FIG. 2 may be a second amplitude demodulator that performs envelope detection based on a detection component. As shown in FIG. 4, a second amplitude demodulator 100B includes an envelope detector 30 and a shaping circuit 40. An output end of the envelope detector 30 is coupled to an input end of the shaping circuit 40.

The envelope detector 30 is configured to: be input with a first analog signal, and output a first envelope signal to the shaping circuit 40. The shaping circuit 40 is configured to obtain a first level signal based on the first envelope signal.

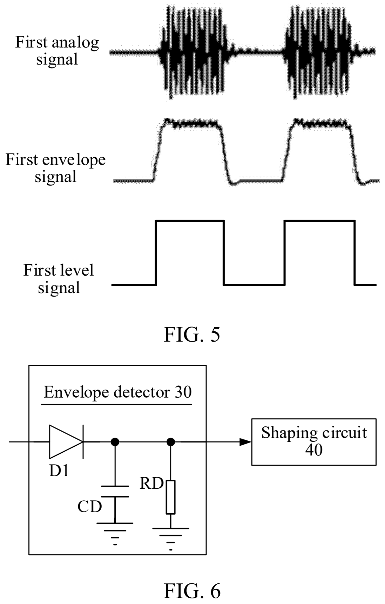

In this embodiment of this application, the first analog signal is a modulation signal obtained through ASK modulation. A first data signal is a data value of the first data signal carried in the modulation signal. As shown in FIG. 5, the envelope detector 30 outputs the first envelope signal based on the first analog signal, where the first envelope signal corresponds to a signal peak envelope of the first analog signal. The shaping circuit 40 obtains the first level signal based on the first envelope signal. The first level signal is a digital signal, and has a constant level (for example, a constant high level corresponds to data 1, and a constant low level corresponds to data 0). The first level signal in a digital signal form is a signal on which the data processor 200 may perform signal data processing. As shown in FIG. 2, the amplitude demodulator 100 outputs the obtained first level signal to the data processor 200, and the data processor 200 performs corresponding data processing based on the first level signal.

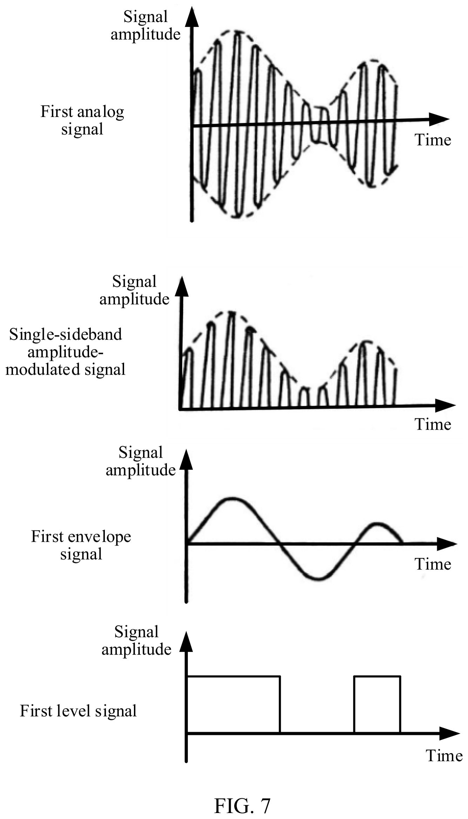

In some examples, the envelope detector 30 shown in FIG. 4 may be based on a detector diode. As shown in FIG. 6, the envelope detector 30 includes a detector diode D1, a filter capacitor CD, and a filter resistor RD. An output end of the detector diode D1 is coupled to the input end of the shaping circuit 40. The filter capacitor CD and the filter resistor RD form a low-pass filter and are coupled to the output end of the detector diode D1. An input end of the detector diode D1 is configured to be input with the first analog signal. The output end of the detector diode D1 is configured to output a single-side amplitude-modulated signal. The low-pass filter formed by the filter capacitor CD and the filter resistor RD is configured to output a baseband envelope signal based on the single-side amplitude-modulated signal, where a signal amplitude of the baseband envelope signal indicates the data value of the first data signal. The shaping circuit 40 obtains the first level signal based on the baseband envelope signal. In this embodiment of this application, the diode has unidirectional conductivity. As shown in FIG. 7, a signal amplitude of the first analog signal carrying the first data signal varies with the data value of the first data signal. After the first analog signal is input to the detector diode D1, only a forward voltage part of the first analog signal may pass through the detector diode D1, so that the detector diode D1 outputs the forward voltage part of the first analog signal, namely, the single-side amplitude-modulated signal. Then, the low-pass filter formed by the filter capacitor CD and the filter resistor RD processes a signal part corresponding to each frequency periodicity of the single-side amplitude-modulated signal. Specifically, as a signal amplitude of the single-side amplitude-modulated signal input to the low-pass filter changes (corresponding to a change of an input voltage), the filter capacitor CD is subject to charge, discharge, and the like, to average the signal amplitude in frequency periodicities of the single-side amplitude-modulated signal, to obtain a baseband envelope signal. A waveform of the baseband envelope signal indicates the data value of the first data signal. Specifically, when a signal amplitude of the baseband envelope signal is greater than a first amplitude (for example, 0), the data value of the first data signal is 1; or when a signal amplitude of the baseband envelope signal is less than or equal to a first amplitude (for example, 0), the data value of the first data signal is 0. The shaping circuit 40 performs shaping on the baseband envelope signal, to obtain the first level signal.

However, in the embodiment shown in FIG. 6, costs of the detector diode D1 are low, but the detector diode D1 has a conduction voltage drop, that is, the detector diode D1 can output a corresponding conduction signal only when the signal amplitude of the first analog signal is greater than the conduction voltage drop of the detector diode D1. Therefore, when a part or all of forward signals of the first analog signal are less than or equal to the conduction voltage drop, the detector diode D1 cannot work normally. The conduction voltage drop of the detector diode D1 is usually at a level of hundreds of millivolts (mV). It means that precision of the detector diode D1 is low, and only a large signal with a large amplitude can be processed. For example, when the signal amplitude of the first analog signal is greater than the conduction voltage drop, but the signal amplitude of a part of the first analog signal is close to the conduction voltage drop, clipping distortion of a bottom signal of the first analog signal by the detector diode D1 may occur, resulting in low detection precision and the like. In addition, when the first analog signal is a signal in a form of a single-side amplitude-modulated signal shown in FIG. 7, the detector diode D1 cannot perform processing applicable to envelope detection.

In some examples, the envelope detector 30 shown in FIG. 4 may be based on a detector tube. Compared with the detector diode D1 shown in FIG. 6, using the detector tube as the envelope detector 30 shown in FIG. 4 can improve processing precision of obtaining an envelope signal based on the first analog signal. However, the detector tube is disposed inside a chip, and can be used only in a scenario of a chip specification. As a result, the detector tube has limited use flexibility, and a dynamic range of usage is limited. In addition, component costs of the detector tube are high, and a processing rate of the detector tube is limited by performance of the chip in which the detector tube is located. Generally, the detector has a low processing rate. If the processing rate of the detector tube needs to be improved, performance of the chip in which the detector tube is located needs to be correspondingly enhanced, resulting in a sharp increase in costs.

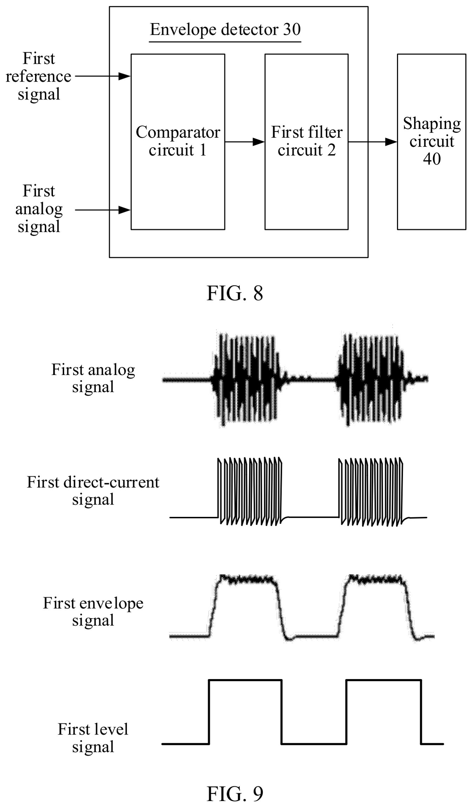

In some possible implementations, to implement detection with a high processing rate and high processing precision at low costs, the envelope detector 30 shown in FIG. 4 may be based on a comparator circuit. As shown in FIG. 8, the envelope detector 30 includes a comparator circuit 1 and a first filter circuit 2. An output end of the comparator circuit 1 is coupled to an input end of the first filter circuit 2. A first input end of the comparator circuit 1 is configured to be input with a first analog signal. A second input end of the comparator circuit 1 is configured to be input with a first reference signal. The comparator circuit 1 is configured to output a first direct-current signal based on the first analog signal and the first reference signal. A level of the first direct-current signal indicates a value relationship between the first analog signal and the first reference signal. The first filter circuit 2 is configured to output a first envelope signal based on the first direct-current signal. A signal amplitude of the first envelope signal indicates a peak of a signal amplitude of the first direct-current signal.

For example, the comparator circuit 1 may be based on a first comparator. In this embodiment of this application, the comparator is a mature component designed in the industry, and has low costs and high availability. In addition, the comparator has high signal processing consistency in a high-temperature environment and a low-temperature environment. A comparison threshold of the comparator is flexibly adjustable (where the threshold can be adjusted by adjusting a value of the first reference signal). The detection threshold of the comparator is at a level of several millivolts (mV), and therefore, the comparator has high detection precision and a high response processing rate. In this embodiment of this application, a solution in which the comparator circuit 1 and the first filter circuit 2 are combined is used. Compared with the foregoing solution in which the detector diode D1 and the detector tube implement envelope detection, this solution has higher reliability, a larger dynamic range, and higher detection sensitivity. In addition, compared with the foregoing embodiment of digital detection shown in FIG. 3, in this embodiment of this application, for example, the embodiment shown in FIG. 8, a circuit structure is simpler, a used component is simpler and maturer, and costs are quite low. In this embodiment of this application, the comparator circuit 1 and the first filter circuit 2 are combined, so that envelope detection with a high processing rate and high processing precision is implemented at low costs.

In the embodiment shown in FIG. 8 of this application, a signal peak of a modulation signal (namely, the first analog signal) obtained through ASK modulation varies with a data value of a first data signal. The first reference signal is set based on a modulation parameter (for example, a signal amplitude) for ASK modulation. The first reference signal and the first analog signal are input to the comparator circuit 1. When the first analog signal is greater than or equal to the first reference signal, the comparator circuit 1 outputs a first level (for example, a high level); or when the first analog signal is less than the first reference signal, the comparator circuit 1 outputs a second level (for example, a low level). The comparator circuit 1 obtains the first direct-current signal in a direct-current signal form based on the first analog signal. When the signal amplitude of the first direct-current signal is greater than 0, a level of the first direct-current signal is the first level, indicating that the first analog signal is greater than or equal to the first reference signal. When the signal amplitude of the first direct-current signal is equal to 0, a level of the first direct-current signal is the second level, indicating that the first analog signal is less than the first reference signal. A value of the first direct-current signal may reflect a correspondence between a signal amplitude of the first analog signal and the data value of the first data signal. The first filter circuit 2 filters out a high-frequency signal in the first direct-current signal, and reserves a low-frequency envelope waveform, to obtain the first envelope signal. The first envelope signal represents a change of a signal peak of the first direct-current signal. When a signal amplitude of the first envelope signal is greater than a second amplitude (for example, 0), the data value of the first data signal is 1; or when a signal amplitude of the first envelope signal is equal to a second amplitude (for example, 0), the data value of the first data signal is 0. The shaping circuit 40 performs shaping on the first envelope signal based on the second amplitude, to obtain a regular first level signal and a level of the first level signal. The first level signal is output to the data processor 200, to complete data processing on the first data signal.

For example, as shown in FIG. 9, ASK modulation is performed based on the first data signal, to obtain the first analog signal. For example, the first data signal includes four bits, and values corresponding to the four bits are 0101. When a carrier signal is modulated through OOK modulation, the four bits of the first data signal are sequentially used to control the modulation switch S1 shown in FIG. 1 to be turned on or turned off, to obtain the first analog signal shown in FIG. 9. The comparator circuit 1 obtains, based on the first reference signal and the first analog signal, the first direct-current signal shown in FIG. 9. It can be learned that a signal segment in which the signal amplitude of the first direct-current signal is greater than 0 corresponds to a first signal segment of the first analog signal, where the first signal segment of the first analog signal is a signal segment corresponding to the first data signal with a value 1. The shaping circuit 40 performs shaping on the first direct-current signal, to obtain a regular first level signal.

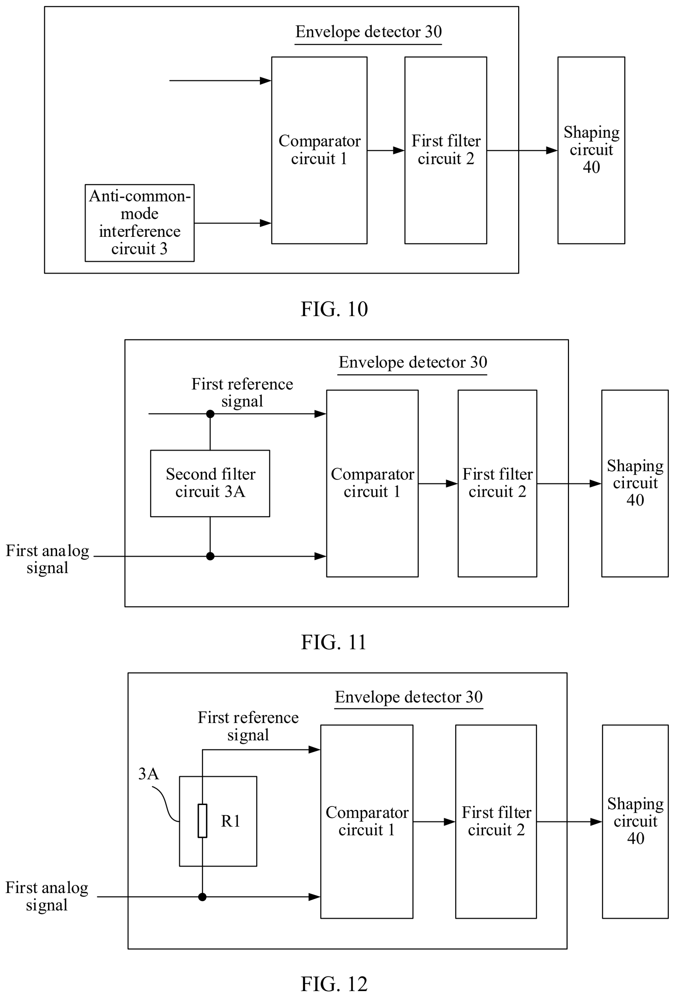

In some possible implementations, the first analog signal carries a common-mode interference signal. As shown in FIG. 10, the envelope detector 30 further includes an anti-common-mode interference circuit 3. The anti-common-mode interference circuit 3 is coupled to the first input end of the comparator circuit 1. In this embodiment of this application, in some application scenarios, there is no common-mode interference signal in the first analog signal. In this case, the first analog signal and the first reference signal may be directly input to the comparator circuit 1 for comparison. In some application scenarios, there is a common-mode interference signal in the first analog signal. In this case, interference of the common-mode interference signal needs to be eliminated, and then the first analog signal is input to the comparator circuit 1, to ensure precision of signal processing.

In some examples, the anti-common-mode interference circuit 3 is a common-mode interference filter circuit. In this case, the anti-common-mode interference circuit 3 is configured to: be input with the first analog signal carrying the common-mode interference signal, and output, to the comparator circuit 1, the first analog signal from which the common-mode interference signal is filtered out. For example, the common-mode interference filter circuit may be an anti-common-mode coupled inductor or the like.

In some examples, as shown in FIG. 11, the anti-common-mode interference circuit 3 is a second filter circuit 3A. A first end of the second filter circuit 3A is coupled to the first input end of the comparator circuit 1. A second end of the second filter circuit 3A is coupled to the second input end of the comparator circuit 1. The second filter circuit 3A is configured to: be input with the first analog signal through the first end of the second filter circuit 3A, and output the common-mode interference signal to the second input end of the comparator circuit 1 through the second end of the second filter circuit 3A. In this embodiment of this application, the second filter circuit 3A is coupled to the first input end and the second input end of the comparator circuit 1. When the first analog signal carrying the common-mode interference signal is input to the first input end of the comparator circuit 1, the second filter circuit 3A filters and transmits the common-mode interference signal from the first input end of the comparator circuit 1 to the second input end of the comparator circuit 1, so that the common-mode interference signal is input to both the first input end and the second input end of the comparator circuit 1. When the comparator circuit 1 compares signals that are input to the first input end and the second input end, interference compensation in a comparison process can be implemented by separately inputting the common-mode interference signal to the two input ends.

In this embodiment of this application, the first analog signal and the common-mode interference signal each are an electromagnetic wave signal with a specific frequency. The common-mode interference signal has a specific frequency response, that is, the common-mode interference signal can be filtered and transmitted only when a transmission path meets a specific frequency response. In this embodiment of this application, a corresponding frequency response relationship may be set for the second filter circuit 3A based on a parameter, for example, a signal frequency in an actual application scenario, to filter and transmit the common-mode interference signal. In some examples, the second filter circuit 3A may be an equivalent resistor, an equivalent capacitor, an equivalent inductor, or the like, or may be a combination of at least two of an equivalent resistor, an equivalent capacitor, and an equivalent inductor.

In some possible implementations, the first reference signal may be proposed to the second input end of the comparator circuit 1 via the second filter circuit 3A.

For example, as shown in FIG. 12, the second filter circuit 3A includes a first equivalent resistor R1. A first end of the first equivalent resistor R1 is coupled to the first input end of the comparator circuit 1. A second end of the first equivalent resistor R1 is coupled to the second input end of the comparator circuit 1. The first equivalent resistor R1 is configured to: be input with the first analog signal through the first end of the first equivalent resistor R1, and output the common-mode interference signal to the second input end of the comparator circuit 1 through the second end of the first equivalent resistor R1. In this embodiment of this application, a resistance value of the first equivalent resistor R1 is set to implement a specific frequency response, so as to filter and transmit the common-mode interference signal. In addition, the first equivalent resistor R1 has a specific resistance value, so that a function of voltage division is achieved. A voltage input to the first equivalent resistor R1 is divided to obtain the first reference signal, and the first reference signal is output to the second input end of the comparator circuit 1.

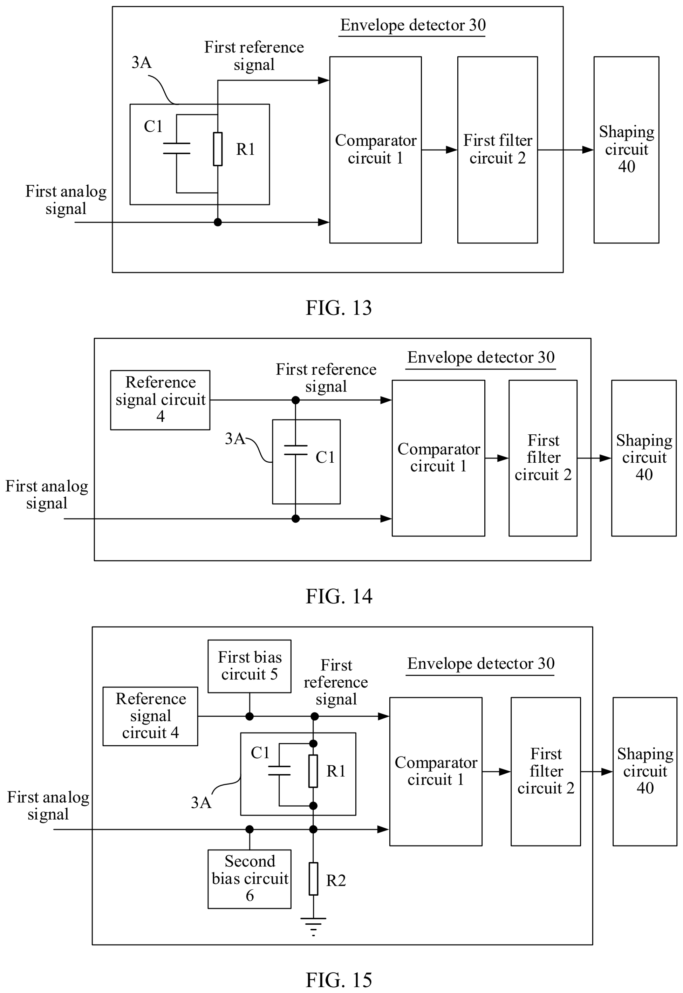

For example, as shown in FIG. 13, the second filter circuit 3A includes a first equivalent resistor R1 and a first equivalent capacitor C1. A first end of the first equivalent capacitor C1 is coupled to the first input end of the comparator circuit 1. A first end of the first equivalent resistor R1 and the first end of the first equivalent capacitor C1 are connected in parallel and then coupled to the first input end of the comparator circuit 1. A second end of the first equivalent resistor R1 and a second end of the first equivalent capacitor C1 are connected in parallel and then coupled to the second input end of the comparator circuit 1. In some examples, the first equivalent capacitor C1 has a frequency response relationship for filtering and transmitting the common-mode interference signal, and the first equivalent resistor R1 does not have a frequency response relationship for filtering and transmitting the common-mode interference signal. In this case, the first equivalent resistor R1 is configured to: be input with the first analog signal through the first end of the first equivalent resistor R1, and output the first reference signal to the second input end of the comparator circuit 1 through the second end of the first equivalent resistor R1. The first equivalent capacitor C1 is configured to: be input with the first analog signal through the first end of the first equivalent capacitor C1, and output the common-mode interference signal to the second input end of the comparator circuit 1 through the second end of the first equivalent capacitor C1. In some examples, the first equivalent capacitor C1 and the first equivalent resistor R1 each have a frequency response relationship for filtering and transmitting the common-mode interference signal. In this case, the first analog signal is input to the first end of the first equivalent capacitor C1 connected to the first equivalent resistor R1 in parallel, the second end of the first equivalent capacitor C1 outputs the common-mode interference signal, and the second end of the second equivalent resistor R2 outputs the first reference signal.

For example, the second filter circuit 3A includes a first equivalent resistor R1 and a first equivalent inductor. In some examples, the first equivalent resistor R1 and the first equivalent inductor are connected in parallel. In some examples, the first equivalent resistor R1 and the first equivalent inductor are connected in series. In this embodiment of this application, the first reference signal is obtained via the first equivalent resistor R1. A frequency response for the common-mode interference signal is implemented via both the first equivalent resistor R1 and the first equivalent inductor, to filter and transmit the common-mode interference signal. Alternatively, a frequency response for the common-mode interference signal is implemented via the first equivalent inductor, to filter and transmit the common-mode interference signal.

In some possible implementations, the first reference signal is proposed to the comparator circuit 1 via a reference signal circuit. As shown in FIG. 14, the envelope detector 30 further includes a reference signal circuit 4. An output end of the reference signal circuit 4 is coupled to the second input end of the comparator circuit 1. The reference signal circuit 4 is configured to output the first reference signal to the first input end of the comparator circuit 1. In this embodiment of this application, a constant first reference signal may be generated via the reference signal circuit 4, and is transmitted to the second input end of the comparator circuit 1.

For example, in the embodiment in which the first reference signal is output via the reference signal circuit 4, the common-mode interference signal may be filtered and transmitted via an equivalent capacitor. As shown in FIG. 14, the first end of the first equivalent capacitor C1 is coupled to the first input end of the comparator circuit 1. The second end of the first equivalent capacitor C1 is coupled to the second input end of the comparator circuit 1. The first equivalent capacitor C1 is configured to: be input with the first analog signal through the first end of the first equivalent capacitor C1, and output the common-mode interference signal to the second input end of the comparator circuit 1 through the second end of the first equivalent capacitor C1. In this embodiment of this application, the common-mode interference signal may be filtered and transmitted via the first equivalent capacitor C1, and the first reference signal is output via the reference signal circuit 4.

For example, in the embodiment in which the first reference signal is output via the reference signal circuit 4, the common-mode interference signal may be filtered and transmitted via the first equivalent inductor. A first end of the first equivalent inductor is coupled to the first input end of the comparator circuit 1, and a second end of the first equivalent inductor is coupled to the second input end of the comparator circuit 1.

In some possible implementations, the first reference signal may be generated via the first equivalent resistor R1 in the second filter circuit 3A and the reference signal circuit 4, and is output to the second input end of the comparator circuit 1.

For example, as shown in FIG. 15, the second filter circuit 3A includes a first equivalent resistor R1. A first end of the first equivalent resistor R1 is coupled to the first input end of the comparator circuit 1. Both a second end of the first equivalent resistor R1 and the output end of the reference signal circuit 4 are coupled to the second input end of the comparator circuit 1. In this embodiment of this application, the first reference signal may be generated via the first equivalent resistor R1 and the reference signal circuit 4, and is output to the second input end of the comparator circuit 1. For related descriptions of filtering and transmitting the common-mode interference signal by the second filter circuit 3A when the first reference signal is generated via the first equivalent resistor R1 in the second filter circuit 3Aand the reference signal circuit 4, refer to related descriptions of filtering and transmitting the common-mode interference signal in the embodiment in which the first reference signal is generated via the reference signal circuit 4 and the embodiment in which the first reference signal is generated via the first equivalent resistor R1 in the second filter circuit 3A. Details are not described herein again.

In some possible implementations, a comparison voltage difference between the first input end and the second input end of the comparator circuit 1 may be adjusted based on different application scenarios. In this embodiment of this application, the comparison voltage difference between the first input end and the second input end of a comparison voltage 1 is related to an amplitude parameter of ASK modulation, demodulation precision of ASK demodulation, and the like. Different comparison voltage differences may be set based on requirements on parameter settings of an actual application component, demodulation precision of an application scenario, and the like. For example, when the first analog signal is not input to the first input end of the comparator circuit 1, while the first reference signal is input to the second input end of the comparator circuit 1, a voltage value at the first input end of the comparator circuit 1 is less than a voltage value at the second input end of the comparator circuit 1, the comparator circuit 1 outputs a low level. During ASK modulation, a minimum value of a signal amplitude of a signal segment that is in the first analog signal and that represents data 1 is 10 mV. In this case, after the first analog signal is input to the first input end of the comparator circuit 1, the first direct-current signal output by the comparator circuit 1 can meet a subsequent demodulation processing requirement provided that the comparison voltage difference is less than or equal to 10 mV.

In some examples, a voltage division degree of the first reference signal may be adjusted, to adjust the comparison voltage difference. For example, as shown in FIG. 15, the envelope detector 30 further includes a second equivalent resistor R2. A first end of the second equivalent resistor R2 is coupled to the first input end of the comparator circuit 1, and a second end of the second equivalent resistor R2 is grounded. In this embodiment of this application, the voltage value at the first input end and/or the voltage value at the second input end of the comparator circuit 1 may be adjusted via the second equivalent resistor R2, to adjust the comparison voltage difference between the first input end and the second input end of the comparator circuit 1.

In some examples, the voltage value at the first input end of the comparator circuit 1 and/or the voltage value at the second input end of the comparator circuit 1 may be adjusted, to adjust the comparison voltage difference.

For example, as shown in FIG. 15, the envelope detector 30 further includes a first bias circuit 5. An output end of the first bias circuit 5 is coupled to the first input end of the comparator circuit 1. The first bias circuit 5 is configured to output a first bias voltage to the first input end of the comparator circuit 1. In this embodiment of this application, the first bias circuit 5 outputs the first bias voltage to the first input end of the comparator circuit 1, to increase the voltage at the first input end of the comparator circuit 1, so as to increase the comparison voltage difference.

For example, as shown in FIG. 15, the envelope detector 30 further includes a second bias circuit 6. An output end of the second bias circuit 6 is coupled to the second input end of the comparator circuit 1. The second bias circuit 6 is configured to output a second bias voltage to the second input end of the comparator circuit 1. In this embodiment of this application, the second bias circuit 6 outputs the second bias voltage to the second input end of the comparator circuit 1, and the voltage value at the second input end of the comparator circuit 1 is increased via the second bias voltage.

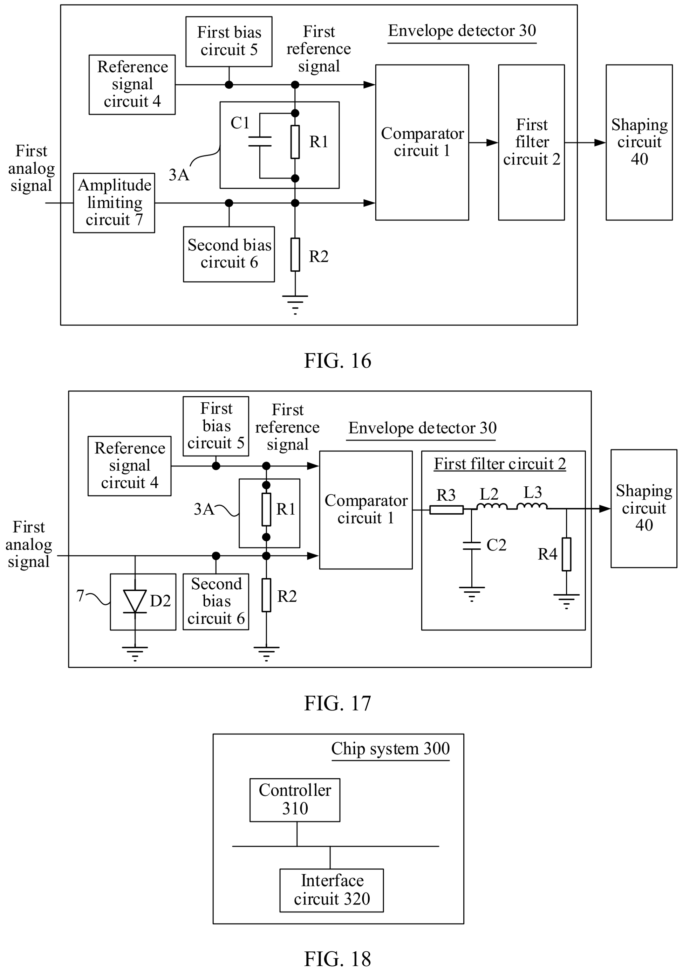

In some possible implementations, as shown in FIG. 16, the envelope detector 30 further includes an amplitude limiting circuit 7. The amplitude limiting circuit 7 is coupled to the first input end of the comparator circuit 1. In this embodiment of this application, the signal amplitude of the first analog signal obtained through ASK modulation changes. In an actual application, based on selection of a component, a maximum signal amplitude of the first analog signal may exceed an amplitude of a signal that can be processed by some components. An excessively large signal amplitude may cause a component loss, a decrease in signal processing precision, or the like. In a demodulation process, data corresponding to a signal segment in which the signal amplitude of the first analog signal is greater than a specific value is considered as data 1, and performing amplitude limiting processing on a large signal amplitude does not affect subsequent demodulation. Therefore, the signal amplitude of the input first analog signal may be processed via the amplitude limiting circuit 7. For example, as shown in FIG. 17, the amplitude limiting circuit 7 may be an amplitude limiting diode D2.

In some possible implementations, in an actual application, the first filter circuit 2 may be adaptively adjusted based on the waveform of the first analog signal obtained through ASK modulation, to filter out a high-frequency signal in the corresponding first direct-current signal and obtain a low-frequency signal representing a peak change of the first direct-current signal.

For example, as shown in FIG. 17, the first filter circuit 2 includes a third equivalent resistor R3, a fourth equivalent resistor R4, a second equivalent inductor L2, a third equivalent inductor L3, and a second equivalent capacitor C2. A first end of the third equivalent resistor R3 is used as the input end of the first filter circuit 2 and is coupled to the output end of the comparator circuit 1. A second end of the third equivalent resistor R3 is coupled to a first end of the third equivalent inductor L3 via the second equivalent inductor L2. A second end of the third equivalent inductor L3 is used as an output end of the first filter circuit 2 and is coupled to the input end of the shaping circuit 40. The second equivalent capacitor C2, after being grounded, is coupled to a second end of the second equivalent inductor L2 and the first end of the third equivalent inductor L3. The fourth equivalent resistor R4, after being grounded, is coupled to the second end of the third equivalent inductor L3.

In some possible implementations, the shaping circuit 40 includes an operational amplifier or a second comparator. A second reference signal and the first direct-current signal are input via the operational amplifier or the second comparator. A value of the second reference signal and the value of the first direct-current signal are compared to output the first level signal.

In some possible implementations, as shown in FIG. 4, the second amplitude demodulator 100B further includes a first amplifier 50. An output end of the first amplifier 50 is coupled to an input end of the envelope detector 30. In this embodiment of this application, when signal power of the first analog signal (namely, the modulation signal) received by the receiving device is high, the amplitude demodulator 100 may directly perform signal processing on the first analog signal. When signal power of the first analog signal is low, the first analog signal may be amplified by the first amplifier 50, and then output to the amplitude demodulator 100 for signal processing.

In some possible implementations, when the electronic device is a transmitting device, the transmitting device may alternatively detect a transmitted ASK signal (namely, the first analog signal) based on the envelope detector, and perform feedback processing or the like based on the detection. For a technical principle and beneficial effects of processing the first analog signal by the transmitting device by using the envelope detector, refer to related descriptions in the foregoing embodiments. Details are not described herein again.

Embodiments of this application provide an envelope detector, an amplitude demodulator, and an electronic device, and are applied to the field of electronic component signal processing technologies. In a conventional envelope detection technology, a manner of implementing envelope detection by using a detector diode has low costs, but an application scenario and detection precision are limited. However, a manner of implementing detection by using a detector tube has high costs, and is limited to an application inside a chip. Consequently, detection performance is limited to performance of the chip. In a digital detection manner, processing precision and a processing rate greatly depend on support of high power consumption and high costs of an analog-to-digital converter, and costs are extremely high. In this embodiment of this application, envelope detection on an ASK signal is implemented by combining a comparator circuit with a first filter circuit. As a common and mature component on the market, the comparator circuit is low in costs. In comparison with the detector diode, in a manner of using the comparator circuit, processing performance consistency of the comparator circuit is high at high and low temperatures, a comparison voltage difference is flexibly adjustable, detection precision (namely, the comparison voltage difference) is at a level of several millivolts, and a response speed is fast. Compared with an implementation in which the detector diode and the detector tube are used, this embodiment of this application has higher reliability, a larger dynamic adjustment range and application range, and higher detection sensitivity. In addition, in this embodiment of this application, a comparator circuit with different performance may be selected based on an application scenario to meet corresponding requirements on a processing rate and processing precision. In an application scenario with high processing precision and a high processing rate, costs of selecting a high-performance comparator circuit are far lower than that in an application scenario of digital detection. In addition, system complexity in a case in which the comparator circuit is combined with the first filter circuit is also far lower than system complexity in the application scenario of digital detection.

An embodiment of this application further provides a chip system. As shown in FIG. 18, a chip system 300 includes at least one controller 310 and at least one interface circuit 320. The at least one controller 310 and the at least one interface circuit 320 may be interconnected through a line. The controller 310 is configured to support the chip system in implementing functions or steps in the foregoing method embodiments. The at least one interface circuit 320 may be configured to receive a signal from another apparatus (for example, a communication interface, a data processing circuit, a baseband signal generation circuit, a power amplification system, an antenna, a processor, or a memory), or send a signal to another apparatus (for example, a communication interface, a data processing circuit, a baseband signal generation circuit, a power amplification system, an antenna, a processor, or a memory). The chip system 300 may include a chip, and may further include another discrete component.

The controller in this embodiment of this application may be a chip. For example, the controller may be a field programmable gate array (field programmable gate array, FPGA), an application specific integrated chip (application specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

It should be understood that sequence numbers of the foregoing processes do not mean execution sequences in various embodiments of this application. The execution sequences of the processes should be determined based on functions and internal logic of the processes, and should not be construed as any limitation on implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device, and method may be implemented in other manners. For example, the described device embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed on a plurality of devices. Some or all of the modules may be selected based on actual needs to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by software, hardware, firmware, or any combination thereof. When a software program is used to implement embodiments, all or some of the embodiments may be implemented in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state drive (Solid State Disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An envelope detector, comprising a comparator circuit and a first filter circuit, wherein an output end of the comparator circuit is coupled to an input end of the first filter circuit, a first input end of the comparator circuit is configured to be input with a first analog signal, a second input end of the comparator circuit is configured to be input with a first reference signal, the first analog signal carries a first data signal, and a signal amplitude of the first analog signal indicates values of a plurality of bits of the first data signal;
the comparator circuit is configured to output a first direct-current signal based on the first analog signal and the first reference signal, wherein a level of the first direct-current signal indicates a value relationship between the first analog signal and the first reference signal; and
the first filter circuit is configured to output a first envelope signal based on the first direct-current signal, wherein a signal amplitude of the first envelope signal indicates values of a plurality of bits of the first data signal.

2. The envelope detector according to claim 1, wherein the first analog signal carries a common-mode interference signal, the envelope detector further comprises an anti-common-mode interference circuit, and the anti-common-mode interference circuit is coupled to the first input end of the comparator circuit.

3. The envelope detector according to claim 2, wherein the anti-common-mode interference circuit is a second filter circuit, a first end of the second filter circuit is coupled to the first input end of the comparator circuit, a second end of the second filter circuit is coupled to the second input end of the comparator circuit, and the second filter circuit is configured to:
be input with the first analog signal through the first end of the second filter circuit, and output the common-mode interference signal to the second input end of the comparator circuit through the second end of the second filter circuit.

4. The envelope detector according to claim 3, wherein the second filter circuit comprises a first equivalent resistor, a first end of the first equivalent resistor is coupled to the first input end of the comparator circuit, a second end of the first equivalent resistor is coupled to the second input end of the comparator circuit, and the first equivalent resistor is configured to:
be input with the first analog signal through the first end of the first equivalent resistor, and output the common-mode interference signal to the second input end of the comparator circuit through the second end of the first equivalent resistor.

5. The envelope detector according to claim 4, wherein the first equivalent resistor is further configured to: output the first reference signal to the second input end of the comparator circuit through the second end of the first equivalent resistor.

6. The envelope detector according to claim 3, wherein the second filter circuit comprises a first equivalent capacitor, a first end of the first equivalent capacitor is coupled to the first input end of the comparator circuit, a second end of the first equivalent capacitor is coupled to the second input end of the comparator circuit, and the first equivalent capacitor is configured to:
be input with the first analog signal through the first end of the first equivalent capacitor, and output the common-mode interference signal to the second input end of the comparator circuit through the second end of the first equivalent capacitor.

7. The envelope detector according to claim 6, wherein the envelope detector further comprises a first equivalent resistor, a first end of the first equivalent resistor and the first end of the first equivalent capacitor are connected in parallel and then coupled to the first input end of the comparator circuit, a second end of the first equivalent resistor and the second end of the first equivalent capacitor are connected in parallel and then coupled to the second input end of the comparator circuit, and the first equivalent resistor is configured to:
be input with the first analog signal through the first end of the first equivalent resistor, and output the first reference signal to the second input end of the comparator circuit through the second end of the first equivalent resistor.

8. The envelope detector according to claim 4 or 7, wherein the envelope detector further comprises a second equivalent resistor, a first end of the second equivalent resistor is coupled to the first input end of the comparator circuit, and a second end of the second equivalent resistor is grounded.

9. The envelope detector according to claim 6, wherein the envelope detector further comprises a reference signal circuit, the second filter circuit comprises the first equivalent capacitor, an output end of the reference signal circuit is coupled to the second input end of the comparator circuit, the first end of the first equivalent capacitor is coupled to the first input end of the comparator circuit, the second end of the first equivalent capacitor is coupled to the second input end of the comparator circuit, and the reference signal circuit is configured to:
output the first reference signal to the first input end of the comparator circuit.

10. The envelope detector according to any one of claims 1 to 9, wherein the envelope detector further comprises a first bias circuit, an output end of the first bias circuit is coupled to the first input end of the comparator circuit, and the first bias circuit is configured to:
output a first bias voltage to the first input end of the comparator circuit.

11. The envelope detector according to any one of claims 1 to 10, wherein the envelope detector further comprises a second bias circuit, an output end of the second bias circuit is coupled to the second input end of the comparator circuit, and the second bias circuit is configured to:
output a second bias voltage to the second input end of the comparator circuit.

12. The envelope detector according to any one of claims 1 to 11, wherein the envelope detector further comprises an amplitude limiting circuit, and the amplitude limiting circuit is coupled to the first input end of the comparator circuit.

13. An amplitude demodulator, comprising a shaping circuit and the envelope detector according to any one of claims 1 to 12, wherein an output end of the envelope detector is coupled to an input end of the shaping circuit;
the envelope detector is configured to: be input with a first analog signal, and output an envelope signal to the shaping circuit, wherein the first analog signal carries a first data signal, and a signal amplitude of the first analog signal indicates values of a plurality of bits of the first data signal; and
the shaping circuit is configured to obtain a first level signal based on the envelope signal, wherein a level of the first level signal indicates values of a plurality of bits of the first data signal.

14. An electronic device, comprising a circuit board and the envelope detector according to any one of claims 1 to 12, wherein the envelope detector is disposed on the circuit board.
